# EUROPEAN PATENT APPLICATION

(11) **EP 2 645 403 A2**
(43) Date of publication of application: **02.10.2013**
(21) Application number: 13160992.7
(22) Date of filing: 26.03.2013
(51) Int. Cl.: H01L 21/02

(54) **Method of manufacturing ferroelectric thin film**

(30) Priority: 29.03.2012 JP 2012076096
(71) Applicant: Mitsubishi Materials Corporation, Chiyoda-ku Tokyo 100-8117 (JP)
(72) Inventor: Iida, Shintaro, Naka-shi, Ibaraki 311-0102 (JP); Sakurai, Hideaki, Naka-shi, Ibaraki 311-0102 (JP)
(74) Representative: Gille Hrabal

(57) **Abstract**

Task: To provide a method of manufacturing a ferroelectric thin film which has an extremely favorable usage efficiency of materials, furthermore, has a desirable film structure, and has excellent electrical characteristics.

Means for resolution: A method of manufacturing a ferroelectric thin film on a lower electrode 20a by electrostatically spraying a ferroelectric thin film-forming sol-gel solution 21 from a spout 14a of a capillary 14 toward the lower electrode 20a of a substrate 20 having the lower electrode 20a so as to coat the sol-gel solution 21 on the lower electrode 20a and form a coated film, drying, calcining, and then firing the coated film so as to crystallize the coated film, in which a distance between the spout 14a of the capillary 14 and the lower electrode 20a and an applied voltage during electrostatic spray are set so that a refractive index during drying and calcination of the coated film becomes 2 or more, and a liquid amount of the sol-gel solution 21 per spray is set so that a film thickness sets in a range of 150 nm or less when the sol-gel solution 21 is coated in a single spray process, calcined, and then fired so as to be crystallized.

## Description

### [Technical Field]

The present invention relates to a method of manufacturing a ferroelectric thin film using an electrostatic spray method, and, more specifically to a method of manufacturing a ferroelectric thin film which has an extremely high usage efficiency of materials, furthermore, has a desirable film structure, and has excellent electrical characteristics.

### [Background Art]

Electronic devices, such as a dynamic random access memory (DRAM), a ferroelectric random access memory (FeRAM), and an RF circuit, include a capacitor which plays a role as a condenser, and the area occupied by the capacitor in a device also has been becoming narrower in accordance with a demand for the miniaturization or high integration of the device in recent years. The capacitor has a basic structure in which a dielectric layer is sandwiched between both electrodes of an upper electrode and a lower electrode, and the electrostatic capacitance of the capacitor is proportional to the relative permittivity of the dielectric layer and the surface areas of the electrodes, but is inversely proportional to the distance between both electrodes, that is, the thickness of the dielectric layer and the like. Since it is not possible to limit the thickness of the dielectric layer, in order to secure a high electrostatic capacitance in a limited occupied area, it is necessary to use a dielectric material having a higher relative permittivity than the dielectric layer.

Therefore, instead of low-permittivity materials of the related art for which SiO₂, Si₃N₄, and the like were used, ferroelectric thin films formed of a perovskite-type oxide, such as barium titanate (BaTiO₃), barium strontium titanate (hereinafter referred to as "BST"), lead titanate (hereinafter referred to as "PT"), lead zirconate titanate (hereinafter referred to as "PZT') or lanthanum-added lead zirconate titanate formed by adding a small amount of lanthanum to PZT (hereinafter referred to as "PLZT"), are attracting attention. As a method of forming a ferroelectric thin film, chemical solution deposition (CSD), such as a sol-gel method, in addition to physical vapor deposition, such as a vacuum deposition method, a sputtering method or a laser ablation method, and chemical vapor deposition (CVD) has thus far been widely and generally used.

Particularly, compared to CVD, the sputtering method, and the like, the sol-gel method does not require a vacuum process so that the manufacturing costs are low, and there is an advantage that it is easy to form a film in a wide area on a substrate. Furthermore, when the composition of a solution material being used for formation of a dielectric thin film is changed, it is easy to obtain the composition of a film at a theoretical ratio, and an extremely thin ferroelectric thin film can be obtained, and therefore the sol-gel method is being expected as a method of forming a high-capacitance thin film capacitor and the like. In a manufacturing method using the sol-gel method, in general, first, a sol-gel solution is prepared, the prepared sol-gel solution is coated on a substrate, and firing and the like are carried out at predetermined temperatures, thereby obtaining a ferroelectric thin film. In a method of manufacturing a ferroelectric thin film using the sol-gel method, a spin coating method and the like have thus far been widely used to coat the sol-gel solution on a substrate. This is because, in a method of manufacturing a ferroelectric thin film using the sol-gel method, the spin coating method is excellent in terms of a possibility of increasing the film thickness uniformity in the substrate surface since a liquid is removed using, for example, a centrifugal force by rotating a substrate at a high speed.

Meanwhile, in the spin coating method, there was a problem in that, when the sol-gel solution is coated on a substrate, since a majority of the material is scattered away from the substrate and thus wasted, the usage efficiency of the material is extremely poor. Therefore, studies are being made regarding manufacturing methods in which a method other than the spin coating method is used, and, as such a manufacturing method, for example, a method of manufacturing a ferroelectric thin film in which electrostatic spray deposition (hereinafter referred to as "ESD") is used to spray the sol-gel solution on a substrate is disclosed (for example, refer to Non Patent Document 1). The method of manufacturing a ferroelectric thin film using ESD is attracting attention particularly in terms of mass production properties or manufacturing costs since, when the sol-gel solution is coated on a substrate, it is possible to deposit approximately 90% of the sol-gel solution sprayed from a spout of a capillary on the substrate so that the usage efficiency of the material is extremely high.

### [Related art document]

### [Non Patent Document]

[Non Patent Document 1] Jpn. J. Appl. Phys. Vol 41 (2002), pp. 4317 to 4320

### [Disclosure of the Invention]

### [Problem that the Invention is to Solve]

However, in the method of manufacturing a ferroelectric thin film using ESD as in Non Patent Document 1, compared to a thin film formed using the spin coating method, there remain many problems in that the ferroelectric thin film is still poor in terms of the film qualities and the like. As a result of studies by the present inventors, it was confirmed that, compared to a thin film formed using the spin coating method, a PZT ferroelectric thin film obtained using the method described in Non Patent Document 1 is liable to become a porous film, and has a tendency of the electrical characteristics, such as relative permittivity, to significantly deteriorate. This is considered to result from that, generally, the method of manufacturing a ferroelectric thin film using ESD is not widely used, and the optimal conditions, such as the applied voltage, the solution feeding amount, and the distance between a capillary which blows a sol-gel solution and a substrate, are not yet sufficiently clarified. In addition, in this method, for an appropriate orientation, a buffer layer is formed using the spin coating method before a film is formed using ESD. While the method described in Non Patent Document 1 is excellent in terms of the usage efficiency of materials compared to a method only using the spin coating method, but it becomes necessary to change the film-forming apparatus and the like during the manufacturing process when it is necessary to form the buffer layer using a sputtering method, and therefore the process becomes more complicated such that, inversely, a hindrance is caused in terms of mass production properties.

An object of the invention is to provide a method of manufacturing a ferroelectric thin film which has an extremely high usage efficiency of materials, has a desirable film structure, and has excellent electrical characteristics.

### [Means for Solving the Problems]

A first aspect of the invention is a method of manufacturing a ferroelectric thin film on a lower electrode by electrostatically spraying a ferroelectric thin film-forming sol-gel solution from a spout of a capillary toward the lower electrode of a substrate having the lower electrode so as to coat the sol-gel solution on the lower electrode and form a coated film, drying, calcining, and then firing the coated film so as to crystallize the coated film, in which a distance between the spout of the capillary and the lower electrode and an applied voltage during electrostatic spray are set so that a refractive index during drying and calcination of the coated film becomes 2 or more, and a liquid amount of the sol-gel solution per spray is set so that a film thickness sets in a range of 150 nm or less when the sol-gel solution is coated in a single spray process, calcined, and then fired so as to be crystallized.

A second aspect of the invention is an invention based on the first aspect, in which, furthermore, the applied voltage during electrostatic spray is set in a range of 15000 V to 20000 V.

A third aspect of the invention is an invention based on the first or second aspect, in which, furthermore, the sol-gel solution is coated only using the electrostatic spray.

A fourth aspect of the invention is an invention based on any one of the first to third aspects, in which, furthermore, the sol-gel solution is coated and calcined on the lower electrode a plurality of times, and then is fired.

### [Advantage of the Invention]

The manufacturing method of the first aspect of the invention is a method of manufacturing a ferroelectric thin film on a lower electrode by electrostatically spraying a ferroelectric thin film-forming sol-gel solution from a spout of a capillary toward the lower electrode of a substrate having the lower electrode so as to coat the sol-gel solution on the lower electrode and form a coated film, drying, calcining, and then firing the coated film so as to crystallize the coated film, in which a distance between the spout of the capillary and the lower electrode and an applied voltage during electrostatic spray are set so that a refractive index during drying and calcination of the coated film becomes 2 or more, and a liquid amount of the sol-gel solution per spray is set so that a film thickness sets in a range of 150 nm or less when the sol-gel solution is coated in a single spray process, calcined, and then fired so as to be crystallized. Thereby, even in a case in which ESD is used for coating of the sol-gel solution, it is possible to obtain a dense oriented film having a columnar film structure, and therefore it is possible to manufacture a ferroelectric thin film having as excellent electrical characteristics as a ferroelectric thin film formed using a spin coating method. In addition, since the usage efficiency of materials is extremely high in ESD compared to the spin coating method, in the manufacturing method of the invention, it is possible to mass-produce ferroelectric thin films having excellent electrical characteristics at low costs.

In the method of the second aspect of the invention, since it is possible to electrostatically atomize the solution in a more stable manner by setting the applied voltage during electrostatic spray in a range of 15000 V to 20000 V, it is possible to manufacture a ferroelectric thin film having more favorable film qualities and excellent electrical characteristics.

In the manufacturing method of the third aspect of the invention, since the sol-gel solution is coated only using the electrostatic spray, the usage efficiency of materials is extremely high compared to a method in which only the spin coating method is used, a method in which the spin coating method is jointly used, or the like.

In the manufacturing method of the fourth aspect of the invention, the sol-gel solution is coated and calcined on the lower electrode a plurality of times, and then is fired. As such, since the sol-gel solution is coated and calcined not once but a plurality of times, an effect of preventing occurrence of cracking can be obtained.

### [Brief Description of the Drawings]

Fig. 1 is a schematic view showing the outline of an ordinary apparatus used in ESD.
Fig. 2 is a photograph of a cross-section of a ferroelectric thin film obtained in Example 1 observed using a scanning electron microscope (SEM).
Fig. 3 is a photograph of a cross-section of a ferroelectric thin film obtained in Comparative example 3 observed using a scanning electron microscope (SEM).

### [Best Mode for Carrying Out the Invention]

Next, embodiments for carrying out the invention will be described based on the accompanying drawings.

The method of manufacturing a ferroelectric thin film of the invention is a method of manufacturing a ferroelectric thin film using a sol-gel method which is an improvement of a method of manufacturing a ferroelectric thin film using ESD for coating of the sol-gel solution.

As a substrate for manufacturing the ferroelectric thin film, a heat-resistant substrate, such as a silicon substrate or a sapphire substrate having a lower electrode formed thereon is used. For the lower electrode formed on the substrate, a material which is conductive and does not react with the ferroelectric thin film, such as Pt, Ir or Ru, is used. The ferroelectric thin film being manufactured is preferably a Pb-containing perovskite-type oxide, and examples thereof include PZT, PLZT, PMnZT, PNbZT, and the like.

The ferroelectric thin film-forming sol-gel solution is composed of organic metallic compounds dissolved in an organic solvent so that raw materials for configuring a complex metal oxide form a ratio which supplies a desirable metal atom ratio.

The raw material of the complex metal oxide is preferably a compound in which organic groups are bonded to the respective metal elements of Pb, La, Zr and Ti through oxygen or nitrogen atoms thereof. Examples thereof include one or two selected from a group consisting of metal alkoxides, metal diol complexes, metal triol complexes, metal carboxylates, metal β-diketonate complexes, metal β-diketoester complexes, metal β-iminoketo complexes and metal amino complexes. A particularly preferable compound is a metal alkoxide, a partial hydrolysate thereof, or an organic salt. Among the above, examples of a Pb compound and a La compound include acetates (lead acetate: Pb(OA_{c})₂, lanthanum acetate: La(OA_{c})₃), lead diisoproproxide: Pb(OiPr)₂, lanthanum triisopropoxide: La(OiPr)₃, and the like. Examples of a Ti compound include alkoxides such as titanium tetraethoxide: Ti(OEt)₄, titanium tetraisopropoxide: Ti(OiPr)₄, titanium tetra n-butoxide: Ti(OiBu)₄, titanium tetraisobutoxide: Ti(OiBu)₄, titanium tetra t-butoxide: Ti(OtBu)₄, and titanium dimethoxy diisopropoxide: Ti(OMe)₂(OiPr)₂. As a Zr compound, the same alkoxide as for the Ti compound is preferable. The metal alkoxide may be used as it is, but a partial hydrolysate thereof may be used in order to accelerate decomposition.

In order to prepare the ferroelectric thin film-forming sol-gel solution, the raw material is dissolved in an appropriate solvent at a ratio corresponding to a desirable ferroelectric thin film composition, and is prepared to a concentration suitable for coating.

The solvent of the ferroelectric thin film-forming sol-gel solution used here is appropriately determined according to the raw material being used, and, generally, it is possible to use a carboxylic acid, an alcohol (for example, ethanol, 1-butanol or propylene glycol which is a polyvalent alcohol), an ester, a ketone (for example, acetone, methyl ethyl ketone), an ether (for example, dimethyl ether, diethyl ether), a cycloalkane (for example, cyclohexane, cyclohexanol), an aromatic-based solvent (for example, benzene, toluene, xylene), other tetrahydrofurane, or a mixed solvent of two or more of the above. Among the above, 1-butanol, ethanol or propylene glycol is particularly preferable in terms of evaporation rate and solubility.

As the carboxylic acid, specifically, n-butyric acid, α-methyl butyrate, i-valeric acid, 2-ethyl butyrate, 2,2-dimethyl butyrate, 3,3-dimethyl butyrate, 2,3-dimethyl butyrate, 3-methylpentanoate, 4-methylpentanoate, 2-ethylpentanoate, 3-ethylpentanoate, 2,2-dimethylpentanoate, 3,3-dimethylpentanoate, 2,3-dimethylpentanoate, 2-ethyl hexanoate or 3-ethyl hexanoate is preferably used.

In addition, as the ester, ethyl acetate, propyl acetate, n-butyl acetate, sec-butyl acetate, tert-butyl acetate, isobutyl acetate, n-amyl acetate, sec-amyl acetate, tert-amyl acetate, isoamyl acetate is preferably used, and, as the alcohol, 1-propanol, 2-propanol, 1-butanol, 2-butanol, isobutyl alcohol, 1-heptanol, 2-heptanol, 2-methyl-2-pentanol or 2-methoxy ethanol is preferably used.

Meanwhile, the total concentration of the raw material of the complex metallic compound in the organic metallic compound solution (sol-gel solution) of the ferroelectric thin film-forming sol-gel solution is preferably set to 10 mass% to 25 mass%.

To the organic metallic compound solution, a β-diketone (for example, acetylacetone, heptafluorobutanoylpivaroyl methane, dipivaroylmethane, trifluoroacetone, benzoylacetone, or the like), a β-ketonic acid (for example, acetoacetic acid, propyonyl acetate, benzoyl acetate, or the like), a β-ketoester (for example, a lower alkyl ester, such as methyl, propyl or butyl, of the above ketonic acid), an oxyacid (for example, lactic acid, glycolic acid, α-hydroxybutyric acid, salicylic acid, or the like), a lower alkyl ester of the above oxyacid, an oxyketon (for example, diacetone alcohol, acetoin, or the like), a diol, a triol, a higher carboxylic acid, an alkanolamine (for example, diethanolamine, triethanolamine, monoethanolamine), a polyvalent amine or the like may be added as a stabilizer at a (the molecular number of the stabilizer)/(the number of metal atoms) of approximately 0.2 to 3 as necessary.

It is preferable to remove particles by carrying out a filtration treatment or the like on the prepared organic metallic compound solution so as to set the number of particles having a particle diameter of 0.5 µm or more (particularly 0.3 µm, and more particularly 0.2 µm) to 50 particles in 1 mL of the solution. When the number of particles having a particle diameter of 0.5 µm or more in the organic metallic compound solution exceeds 50 particles/mL, the long-term storage stability deteriorates. The number of particles having a particle diameter of 0.5 µm or more in the organic metallic compound solution is preferably smaller, and is particularly preferably 30 particles/mL or less.

A method of treating the prepared organic metallic compound solution so as to obtain the above number of particles is not particularly limited, and examples thereof include the following methods. The first method is a filtration method in which a commercially available membrane filter having a pore diameter of 0.2 µm is used, and the solution is pressure-fed using a syringe. The second method is a pressure filtration method in which a commercially available membrane filter having a pore diameter of 0.05 µm and a pressurized tank are combined. The third method is a circulation filtration method in which the filter used in the second method and a solution circulation tank are combined.

In any methods, the particle capture rate of the filter differs depending on the solution pressure-feeding force. It is generally known that the capture rate increases as the pressure decreases, and, particularly, in the first and second method, in order to realize the condition that the number of particles having a particle diameter of 0.5 µm or more is set to 50 or less, the solution is preferably passed through the filter extremely slowly at a lower pressure.

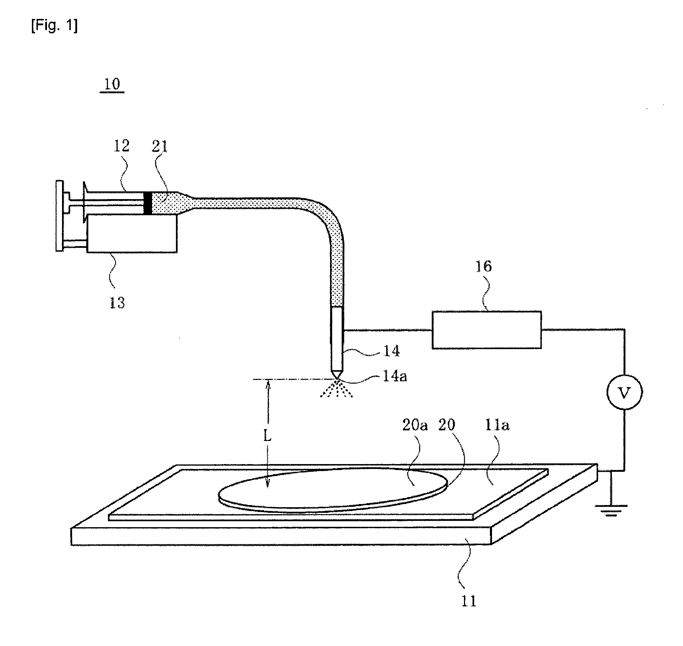

In the method of manufacturing the ferroelectric thin film of the invention, the prepared sol-gel solution is coated using, for example, an apparatus 10 shown in Fig. 1 through ESD. The apparatus 10 shown in Fig. 1 is provided with a stage 11 for mounting a substrate 20, which is a subject to be coated during electrostatic spray, or the like, and a conduction layer 11a is provided on the surface of the stage 11. In addition, a syringe 12 for storing the sol-gel solution 21, which serves as a raw material, and a pump 13 for pressure-feeing the sol-gel solution 21 loaded in the syringe 12 are provided. In addition, the metal capillary 14 for spraying the sol-gel solution 21 sent out from the syringe 12 toward the substrate 20 mounted on the conduction layer 11a of the stage 11 is provided. The capillary 14 is disposed so that the spout 14a provided at the front end of the capillary 14 faces the surface of the stage 11. In addition, the stage 11 is provided to be vertically movable so that the distance between the spout 14a and the substrate 20 and the like mounted on the stage 11 can be arbitrarily adjusted. In addition, a high-pressure power supply apparatus 16 for applying a direct high voltage to the conduction layer 11a of the stage 11 and the sol-gel solution 21 sprayed from the capillary 14 or the spout 14a of the capillary 14 is provided. In ESD, the subjects to be coated, such as the substrate 20 and the like mounted on the stage 11, are used as the positive electrode, the capillary 14 is used as the negative electrode, and a direct high voltage is applied using the high-pressure power supply apparatus 16, thereby producing an electrostatic field between both electrodes. In addition, it is possible to efficiently coat the solution by adsorbing the negatively charged misty sol-gel solution 21 to the substrate 20 and the like charged to be the opposite polarity.

In order to manufacture the ferroelectric thin film using ESD, first, the ferroelectric thin film-forming sol-gel solution 21 is loaded into the syringe 12 provided in the apparatus 10, and the substrate 20 having the lower electrode 20a is mounted on the conduction layer 11 a of the stage 11. In addition, the pump 13 is activated in a state in which a desirable direct high voltage is applied using the high-pressure power supply apparatus 16, and the sol-gel solution 21 loaded in the syringe 12 is pressure-fed. Thereby, a predetermined liquid amount of the sol-gel solution 21 is electrostatically sprayed from the spout 14a of the capillary 14 toward the lower electrode 20a of the substrate 20, and the sol-gel solution 21 is coated on the lower electrode 20a of the substrate 20.

In the method of manufacturing the ferroelectric thin film of the invention, when the sol-gel solution 21 is sprayed and coated on the lower electrode 20a of the substrate 20 using electrostatic spray, the distance between the spout 14a of the capillary 14 and the lower electrode 20a on the surface of the substrate 20 mounted on the stage 11 (hereinafter referred to as the inter-substrate distance L) and the applied voltage during electrostatic spray are set so that the refractive index after drying and calcination of the coated film becomes 2 or more, and the liquid amount of the sol-gel solution per spray is set so that the film thickness becomes 150 nm or less when the sol-gel solution is coated with a single spray process, calcined, and then fired so as to be crystallized. Thereby, it is possible to obtain a dense and high-quality oriented film having a columnar film structure, and it is possible to manufacture a ferroelectric thin film having excellent electrical characteristics. The reason for setting the inter-substrate distance L so that the refractive index of the coated film after calcination and firing becomes 2 or more is to deposit the sol-gel solution sprayed from the spout of the capillary on the substrate in a state in which desirable dampness is retained. The technical reason why a ferroelectric thin film having a desirable film structure can be obtained when the sol-gel solution is deposited on the substrate in a state in which desirable dampness is retained is considered to be that non-volatile components and volatile components in the solution are deposited at an appropriate proportion on the substrate. Meanwhile, when the sol-gel solution is deposited on the substrate in an almost dried state, non-volatile components turn into a particle form, and are deposited on the substrate, and therefore a ferroelectric thin film having a desirable film structure cannot be formed.

As the inter-substrate distance L increases, the solvent component and the like in the sol-gel solution are evaporated more until reaching the substrate such that the sol-gel solution sprayed from the spout of the capillary is deposited in a dried state. Therefore, in order for the sol-gel solution to be deposited on the substrate in a state in which desirable dampness is retained, it is preferable to control the distance simply using an actual measurement value of the inter-substrate distance L; however, since the actual measurement value of the inter-substrate distance L is significantly influenced by apparatus-dependent errors and the like, it is difficult to accurately control the inter-substrate distance L for obtaining favorable film qualities. Therefore, in the invention, the relationship between the degree of dampness in the coated film deposited on the substrate and the refractive index of the coated film formed on the substrate after drying and calcination is found, and the inter-substrate distance L is accurately controlled using the refractive index, thereby significantly reducing apparatus-dependent errors and the like.

When the inter-substrate distance L is set so that the refractive index after drying and calcination becomes less than 2, the sol-gel solution is deposited on the substrate in an almost dried state, and therefore it is not possible to form a ferroelectric thin film having a desirable film structure due to the above reason. Among the above, the inter-substrate distance L is preferably set so that the refractive index of the coated film after drying and calcination becomes 2 to 3. Meanwhile, the refractive index after drying and calcination refers to the refractive index of a coated film after the sol-gel solution is coated on the substrate so as to form the coated film, and then the coated film is dried and calcined under the conditions described below.

In addition, the reason for setting the liquid amount of the sol-gel solution per spray so that the film thickness of the fired thin film formed in a single spray process becomes 150 nm or less is that, in a case in which the liquid amount at this time is set to an amount exceeding 150 nm in the film thickness, there is a disadvantage that cracking occurs or a desirable columnar structure cannot be obtained. Among the above, the liquid amount is preferably set to an amount at which the film thickness is in a range of 20 nm to 150 nm.

In addition, the applied voltage during electrostatic spray is set so that the refractive index after drying and calcination becomes 2 or more. When the applied voltage during electrostatic spray is too low, it becomes difficult to electrostatically atomize the solution in a stable manner. Among the above, the applied voltage during the electrostatic spray is preferably set in a range of 15000 V to 20000 V. In addition, the atmosphere during electrostatic spray is not particularly limited, and electrostatic spray may be carried out in the atmosphere.

In addition, in the method of manufacturing the ferroelectric thin film of the invention, the sol-gel solution is desirably coated only using electrostatic spray. In the manufacturing method of the invention, when the ferroelectric thin film is formed under the above conditions, it is possible to form a film which is excellent in terms of orientation without carrying out coating of the sol-gel solution using the spin coating method, such as forming a buffer layer in advance using the spin coating method. Therefore, the usage efficiency of the material is high, and the mass production properties are also excellent compared to not only the method in which coating is carried out only using the spin coating method but also the method in which the spin coating method is jointly used.

After the sol-gel solution is coated using ESD and a coated film is formed, the coated film is dried, calcined, and then fired so as to be crystallized. Drying and calcination are preferably carried out in the atmosphere at 150°C to 550°C for 1 minute to 10 minutes using a hot plate or the like.

Since drying and calcination is carried out in order to remove the solvent and to thermally decompose or hydrolyze the metallic compound so as to transform into a complex oxide, drying and calcination are desirably carried out in the air, an oxidation atmosphere, or a water vapor-containing atmosphere. Even during heating in the air, moisture necessary for hydrolysis is sufficiently secured from the humidity in the air. The heating is preferably carried out in two steps of low-temperature heating for removing the solvent and high-temperature heating for decomposing the organic metallic compound.

Meanwhile, the processes for coating using ESD to drying and calcination of the sol-gel solution may be carried out once respectively, but it is desirable to repeat the processes through calcination a plurality of times so as to obtain a desirable film thickness and then, finally, to carry out firing collectively.

Firing is a process for firing the dried and calcined coated film at a temperature of the crystallization temperature or higher so as to crystallize the coated film, which produces a ferroelectric thin film. The firing atmosphere in the crystallization process is preferably O₂, N₂, Ar, N₂O, H₂, a mixed gas thereof, and the like. Firing is carried out at 450°C to 800°C for approximately 1 minute to 60 minutes. Firing may be carried out using an abrupt heating treatment (RTA treatment). In a case in which firing is carried out using an RTA treatment, the temperature-increase rate is preferably set to 10°C/second to 100°C/second.

Using the above processes, the ferroelectric thin film can be obtained. The ferroelectric thin film is a thin film obtained using a method in which ESD is used, but is a ferroelectric thin film obtained using the manufacturing method of the invention in which the conditions when the solution is coated using ESD are accurately controlled, and therefore a high refractive index of 2 or more, which is the same as for a thin film obtained using a manufacturing method in which the spin coating method is used, and a high relative permittivity of 1000 or more are achieved.

Therefore, the ferroelectric thin film obtained using the manufacturing method of the invention can be preferably used as a component material in a complex electronic component such as a thin film condenser, a capacitor, an IPD, a DRAM memory condenser, a laminated condenser, a gate insulator of a transistor, a non-volatile memory, a pyroelectric infrared detecting element, a piezoelectric element, an electro-optic element, an actuator, a resonate, an ultrasonic motor or an LC noise filter element.

### [Examples]

Next, examples of the invention will be described in detail along with comparative examples.

### <Example 1>

First, Zr tetra-n-butoxide (Zr source), Ti isopropoxide (Ti source), and acetyl acetone (stabilizer) are put into a reaction vessel, and are refluxed in a nitrogen atmosphere. Next, lead acetate trihydrate (Pb source) is added to this compound, propylene glycol (solvent) is added, the solution is refluxed in a nitrogen atmosphere, and is distilled under reduced pressure so as to remove the byproducts. After that, propylene glycol is further added to the solution so as to adjust the concentration, and, furthermore, a diluted alcohol is added, thereby adjusting the total of the complex metal oxide material in the sol-gel solution to 10 mass%. Thereby, a ferroelectric thin film-forming sol-gel solution containing a metallic compound having a ratio of the respective metals of Pb/Zr/Ti=110/52/48 was obtained. This sol-gel solution was pressure-fed and filtered using a commercially available membrane filter having a pore diameter of 0.2 µm and a syringe so that the number of particles having a particle diameter of 0.5 µm or more in 1 mL of the solution was one.

Next, a ferroelectric thin film was formed on the lower electrode 20a of the substrate 20 on which the lower electrode 20a was formed through ESD in the atmosphere using the apparatus 10 shown in Fig. 1. Specifically, first, the prepared ferroelectric thin film-forming sol-gel solution 21 was loaded in the syringe 12 provided in the apparatus 10. In addition, a silicon substrate 20 having a 0.2 µm-thick Pt lower electrode 20a formed using a sputtering method on the surface was prepared as the substrate 20, and the substrate 20 was mounted on an aluminum conduction layer 11a of the stage 11 in the apparatus 10. In addition, the pump 13 was activated in state in which a desirable direct high voltage was applied using the high-pressure power supply apparatus 16, the sol-gel solution 21 loaded in the syringe 12 was pressure-fed, and the sol-gel solution 21 was electrostatically sprayed at a predetermined liquid amount from the spout 14a of the capillary 14 toward the Pt lower electrode 20a of the substrate 20. Thereby, the sol-gel solution 21 was coated on the Pt lower electrode 20a of the substrate 20 so as to form a coated film. The film-forming conditions using ESD at this time are shown in Table 1 below. The inter-substrate distance L is a value of the distance from the spout 14a of the capillary 14 to the Pt lower electrode 20a converted to the refractive index after the coated film is dried and calcined under the following conditions. In addition, the refractive index after drying and calcination is a value measured using the same method as for the refractive index of the following PZT ferroelectric thin film. Meanwhile, in the example, specifically, the refractive index was measured using an ESD apparatus manufactured by Fuence Co., Ltd. (model name: Esprayer ES-2000S) with the actual measurement value of the inter-substrate distance L set to 3 cm. In addition, the liquid amount per spray is a value obtained by dividing the film thickness of a ferroelectric thin film obtained after the following firing by the number of spray.

Next, drying and calcination were carried out using a hot plate in the atmosphere at a temperature of 300°C for 5 minutes. The processes from coating of the sol-gel solution using the ESD to drying and calcination were repeated 12 times so as to obtain a coated film having a desirable film thickness.

Finally, this film-attached substrate was fired through RTA in an oxygen atmosphere at a temperature-increase rate of 10°C/second and 700°C for 1 minute, thereby forming a PZT ferroelectric thin film made of a complex metallic compound having a metal ratio of Pb/Zr/Ti=110/52/48.

### <Comparative examples 1 and 2>

PZT ferroelectric thin films were formed in the same manner as in Example 1 except that the inter-substrate distances L were set to the values shown in Table 1, and the processes from coating to drying and calcination were repeated once when the sol-gel solution was coated using ESD. Specifically, the same apparatus as the apparatus used in Example 1 was used, and the actual measurement values of the inter-substrate distance L were set to 15 cm and 1 cm respectively. Meanwhile, in Comparative example 2, since the film thickness of the fired PZT ferroelectric thin film could not be measured, the liquid amounts per spray shown in Table 1 are values assumed from Comparative example 1 in which the amount of materials used was the same.

### <Comparative examples 3 and 4>

PZT ferroelectric thin films were formed in the same manner as in Example 1 except that the liquid amounts per spray were adjusted to the amounts shown in Table 1 below, and the processes from coating to drying and calcination were repeated six times and four times when the sol-gel solution was coated using ESD. Meanwhile, in Comparative example 4, since the film thickness of the fired PZT ferroelectric thin film could not be measured, the liquid amounts per spray shown in Table 1 are values assumed from Example 1 and Comparative example 3 in which the amount of materials used was the same.

### <Examples 2 and 3, and Comparative example 5>

PZT ferroelectric thin films were formed in the same manner as in Example 1 except that the applied voltages were set to the voltages shown in Table 1, and the processes from coating to drying and calcination were repeated once when the sol-gel solution was coated using ESD. Meanwhile, in Comparative example 5, since the film thickness of the fired PZT ferroelectric thin film could not be measured, the liquid amounts per spray shown in Table 1 are values assumed from Examples 2 and 3 and Comparative example 1 in which the amount of materials used was the same.

### <Comparative example 6>

A PZT ferroelectric thin film was formed in the same manner as in Example 1 except that ESD was not used for coating of the sol-gel solution, and the sol-gel solution was coated only using the spin coating method. The coating of the sol-gel solution using the spin coating method was carried out under conductions of a rotation speed of 2000 rpm for 10 seconds.

**[Table 1]**

| | Inter-substrate distance L | | Applied voltage M | Liquid amount per coating (film thickness/num ber of times of coating) [nm] | Number of times of coating, drying, calcination [times] | Coating method |
|---|---|---|---|---|---|---|
| | Converted value of refractive index of dried and calcined coated film | Actual measure ment value [cm] | | | | |
| Example 1 | 2.1 | 3 | 20000 | 83 | 12 | ESD |
| Comparative example 1 | 1.2 | 15 | 20000 | 80 | 1 | ESD |
| Com parative example 2 | Not measurable | 1 | 20000 | 80 | 1 | ESD |
| Comparative example 3 | 2.0 | 3 | 20000 | 167 | 6 | ESD |
| Comparative example 4 | Not measurable | 3 | 20000 | 250 | 4 | ESD |
| Example 2 | 2.0 | 3 | 15000 | 80 | 1 | ESD |
| Example 3 | 2.1 | 3 | 20000 | 80 | 1 | ESD |
| Comparative example 5 | Not measurable | 3 | 10000 | 80 | 1 | ESD |
| Com parative example 6 | 2.1 | - | - | 80 | 12 | Spin |

### <Comparison tests and evaluation>

For the ferroelectric thin films obtained in Examples 1 to 3 and Comparative examples 1 to 6, the film thicknesses, film structures, refractive indexes, and relative permittivity were evaluated. The results are shown in Table 2 below. In addition, the amounts of the sol-gel solution used for forming the ferroelectric thin films are shown in Table 2.

(1) Film thickness: the thickness of a cross-section of the obtained ferroelectric thin film was measured using a scanning electron microscope (manufactured by HITACHI Science System, Ltd.; model: S-4300SE). Meanwhile, in Table 2, for Comparative examples 2, 4 and 5 for which the film thicknesses could not be measured, values assumed from the examples or the comparative examples in which the amounts of materials used were the same are shown in parentheses.

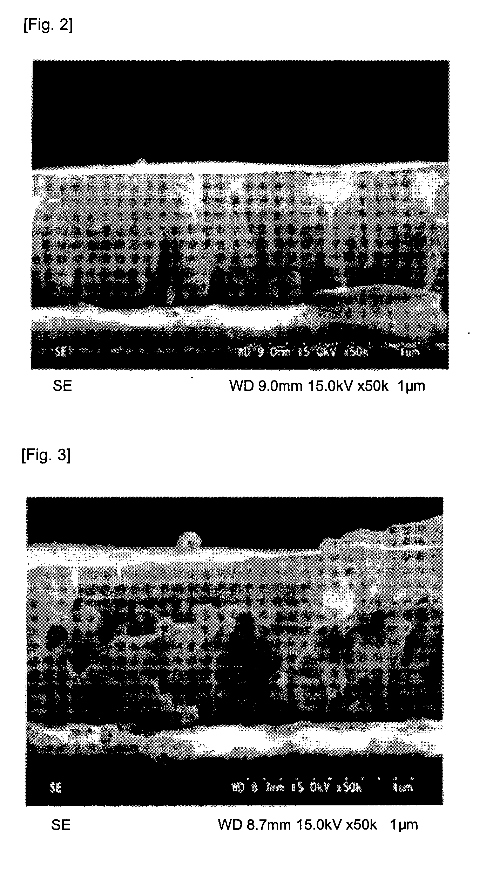

(2) Film structure: the structure of the film cross-section was observed from a SEM image using the scanning electron microscope used for the measurement of the film thickness. The photographs of Example 1 and Comparative example 3 observed at this time are shown in Figs. 2 and 3 as typical views. In addition, in Table 2, "favorable" indicates a case in which a desirable columnar film structure was observed in the SEM image, and "poor" indicates a case in which the structure was not a desirable film structure, such as a grainy film structure.

(3) Refractive index: the refractive index was measured using a spectroscopic ellipsometer (manufactured by J.A.Woollam Co., Inc.; model: M-2000D1).

(4) Relative permittivity: the relative permittivity was measured using a TF analyzer (manufactured by aixACCT Systems GmbH; model: TF ALALYZER 2000).

(5) Crystal orientation: the ferroelectric thin film was measured using an X-ray diffraction apparatus (XRD; manufactured by Bruker Japan Co., Ltd.: MXP18HF), and, among the obtained diffraction results, the oriented plane having a highest intensity was considered as the preferentially oriented plane.

**[Table 2]**

| | Ferroelectric thin film | | | | | | | |
|---|---|---|---|---|---|---|---|---|
| | Film thickness [nm] | Pb/Zr/Ti | Film structure | Refractive index | Relative perm ittivity | Presence of cracks | Orientation | Amount of materials used [µL] |
| Example 1 | 1000 | 110/52/48 | Favorable | 2.5 | 1100 | No | 111 | 300 |
| Comparative example 1 | 80 | 110/52/48 | Poor | 1.1 | Not measurable | No | Not-oriented | 25 |
| Com parative example 2 | Not measurable (80) | 110/52/48 | Poor | Not measurable | Not measurable | No | 111 | 25 |
| Comparative example 3 | 1000 | 110/52/48 | Poor | 2.4 | Not measurable | No | 111 | 300 |
| Comparative example 4 | Not measurable (1000) | 110/52/48 | Poor | Not measurable | Not measurable | Yes | 111 | 300 |
| Example 2 | 80 | 110/52/48 | Favorable | 2.4 | 1100 | No | 111 | 25 |
| Example 3 | 80 | 110/52/48 | Favorable | 2.4 | 1100 | No | 111 | 25 |
| Comparative example 5 | Not measurable (80) | 110/52/48 | Poor | Not measurable | Not measurable | No | 111 | 25 |
| Com parative example 6 | 1000 | 110/52/48 | Favorable | 2.5 | 1300 | No | 111 | 840 |

As is evident from Tables 1 and 2, when Example 1 and Comparative examples 1 to 4 are compared, for Comparative example 1 in which the inter-substrate distance was set so that the refractive index after drying and calcination of 2 or more was not satisfied, the refractive index of the tin film formed after firing produced an unsatisfactory result of less than 2, and the leakage current of the film was not large such that the relative permittivity could not be measured. In addition, a desirable orientation could not be obtained. Meanwhile, as shown in Comparative example 2, in the apparatus used in the present example and the comparative examples, in a case in which the actual measurement value of the inter-substrate distance was set to 1 cm, the film variation became large, and the refractive index after drying and calcination could not be measured. In addition, the film thicknesses of the formed ferroelectric thin films could not be measured.

In addition, in Comparative example 3 in which the liquid amount of the sol-gel solution per spray was set so that the film thickness of a fired thin film formed with a single spraying process became 167 nm, as shown in Fig. 2, a granny film structure was formed, and the leakage current of the film became large such that the relative permittivity of the formed thin film could not be measured. In addition, in Comparative example 4 in which the liquid amount was set so that the film thickness became 250 nm, cracking occurred in the formed thin film, and therefore the film thickness, refractive index and relative permittivity could not be measured.

In contrast, in Example 1, it was possible to form a thin film which had no cracks, had a desirable columnar film structure and a high refractive index, and had excellent electrical characteristics.

In addition, when Examples 2 and 3 and Comparative example 5 are compared, for Examples 2 and 3 in which the applied voltage during electrostatic spray was set so that the refractive index after drying and calcination became 2 or more, it was possible to form a thin film having a desirable columnar film structure and a high refractive index and having excellent electrical characteristics. Meanwhile, as shown in Comparative example 5, in the apparatus used in the present example and the comparative examples, in a case in which the applied voltage during electrostatic spray was set to 10000 V, it was not possible to electrostatically atomize the sol-gel solution in a stable manner, the film variation became large, and the refractive index after drying and calcination could not be measured. In addition, the film thicknesses of the formed ferroelectric thin films could not be measured.

In addition, when Examples 1 to 3 and Comparative example 6 are compared, in Examples 1 to 3, similarly to Comparative example 6 in which the thin film was formed using the spin coating method, it was possible to form a thin film which had no cracks, had a desirable columnar film structure and a high refractive index, and had excellent electrical characteristics. Furthermore, in Examples 1 to 3, it is found that the usage efficiency of materials is extremely high compared to Comparative example 6.

### [Industrial Applicability]

The invention can be used to manufacture a component material and the like for complex electronic components, such as a thin film condenser, a capacitor, an IPD, a DRAM memory condenser, a laminated condenser, a gate insulator of a transistor, a non-volatile memory, a pyroelectric infrared detecting element, a piezoelectric element, an electro-optic element, an actuator, a resonate, an ultrasonic motor or an LC noise filter element.

### [Reference Numerals]

| | |
|---|---|
| 10 | ELECTROSTATIC SPRAY APPARATUS |
| 11 | STAGE |
| 11a | CONDUCTIVE LAYER |
| 12 | SYRINGE |
| 13 | PUMP |
| 14 | CAPILLARY |
| 14a | SPOUT |
| 16 | HIGH-VOLTAGE POWER SUPPLY APPARATUS |
| 20 | SUBSTRATE |
| 20a | LOWER ELECTRODE |
| 21 | FERROELECTRIC THIN FILM-FORMING SOL-GEL SOLUTION |

## Claims

1. A method of manufacturing a ferroelectric thin film on a lower electrode by electrostatically spraying a ferroelectric thin film-forming sol-gel solution from a spout of a capillary toward the lower electrode of a substrate having the lower electrode so as to coat the sol-gel solution on the lower electrode and form a coated film, drying, calcining, and then firing the coated film so as to crystallize the coated film,
wherein a distance between the spout of the capillary and the lower electrode and an applied voltage during electrostatic spray are set so that a refractive index during drying and calcination of the coated film becomes 2 or more, and a liquid amount of the sol-gel solution per spray is set so that a film thickness sets in a range of 150 nm or less when the sol-gel solution is coated in a single spray process, calcined, and then fired so as to be crystallized.

2. The method of manufacturing a ferroelectric thin film according to Claim 1,
wherein the applied voltage during electrostatic spray is set in a range of 15000 V to 20000 V.

3. The method of manufacturing a ferroelectric thin film according to Claim 1 or 2,
wherein the sol-gel solution is coated only using the electrostatic spray.

4. The method of manufacturing a ferroelectric thin film according to any one of Claims 1 to 3,
wherein the sol-gel solution is coated and calcined on the lower electrode a plurality of times, and then is fired.
